# EUROPEAN PATENT APPLICATION

(11) **EP 4 790 373 A1**
(43) Date of publication of application: **12.08.2026**
(21) Application number: 25747881.8
(22) Date of filing: 24.01.2025
(51) Int. Cl.: G01K 13/00

(54) **POWER SUPPLY APPARATUS**

(30) Priority: 31.01.2024 US 202463627094 P
(71) Applicant: Delta Electronics, Inc., Taoyuan City 333 (TW)
(72) Inventor: LIU, Hung-Hsiao, Taoyuan City Taiwan 333 (TW); CHENG, Chang-Yi, Taoyuan City Taiwan 333 (TW); SU, Wei-Te, Taoyuan City Taiwan 333 (TW)
(74) Representative: Nederlandsch Octrooibureau
(86) International application number: PCT/CN2025/074924
(87) International publication number: WO 2025/162313

(57) **Abstract**

A power supply apparatus (100), comprising a motor (MOT1), a circuit measurer (120), a temperature sensor (130) and a computing circuit (140). The circuit measurer (120) is configured to measure the operating frequency of the motor (MOT1) and a current that flows into the motor (MOT1) via a busbar. The temperature sensor (130) is configured to measure an initial temperature of a stator (MS_U) of the motor (MOT1) in an initial state. The computation circuit (140) is coupled to the circuit measurer (120) and the temperature sensor (130). The computation circuit (140) is configured to: execute a power model, so as to calculate a first transient power of the motor (MOT1) on the basis of the initial temperature, the operating frequency and the current; and execute a thermal model, so as to calculate a first transient ideal temperature of the motor (MOT1) on the basis of the first transient power. The power supply apparatus (100) measures the operating frequency and current of the motor (MOT1), so as to calculate a transient temperature of the stator (MS_U) of the motor (MOT1) in real time.

## Description

### BACKGROUND

### Field of Invention

This disclosure relates to a power supply device and a temperature measuring method, and in particular to the power supply device and the temperature measuring method for estimating a transient temperature.

### Description of Related Art

Thermal management systems usually rely on basic thermal models and require manual calibration. Under varying operating conditions, this approach can lead to inefficiencies and possible failures. A temperature measuring device can be configured to measure operating ambient temperature of a circuit device. However, the temperature measuring device is mainly able to measure a steady-state temperature of the circuit device, such as temperature changes every 10 seconds during the continuous operation of the circuit device. The steady-state temperature measurement can only represent an overall operating ambient temperature of the circuit device, and cannot detect a transient temperature of a core circuit in the circuit device at a specific moment (for example, measuring the temperature of rotor of a motor at the moment of operating).

Since temperature measuring devices cannot measure or calculate the transient temperature of a specific component inside a circuit in real time, this may make temperature monitoring difficult.

### SUMMARY

The present disclosure provides a power supply device. The power supply device comprises a motor, a circuit measuring device and a computing circuit. The circuit measuring device is configured to measure an operating frequency of the motor and a current flowing into the motor through a bus. The temperature sensor is configured to measure an initial temperature of a stator of the motor in an initial phase. The computing circuit is coupled to the circuit measuring device and the temperature sensor. The computing circuit is configured to: execute a power model, based on the initial temperature, the operating frequency and the current, calculate to obtain a first transient power of the motor; and execute a thermal model, based on the first transient power to calculate to obtain a first transient ideal temperature of the motor.

The present disclosure provides a power supply device. The power supply device comprises a motor, a circuit measuring device and a computing circuit. The circuit measuring device is configured to measure an operating frequency of the motor and a current flowing into the motor through a bus. The temperature sensor is configured to measure an initial temperature of a stator of the motor in an initial phase. The computing circuit is coupled to the circuit measuring device and the temperature sensor. The computing circuit comprises an analog-to-digital converter, a digital signal processor, a power estimating unit and a temperature estimating unit. The analog-to-digital converter is configured to receive the initial temperature from the temperature sensor, wherein the initial temperature is an analog signal. The digital signal processor is configured to convert the initial temperature into a digital initial temperature, wherein the digital initial temperature is a digital signal. The power estimating unit is configured to calculate to obtain a first transient power of the motor based on the digital initial temperature, the operating frequency, and the current. The temperature estimating unit is configured to calculate to obtain a first transient ideal temperature based on the first transient power.

In summary, the power supply device of the present disclosure can just measure the operating frequency and the current of the motor, and then instantly calculate to obtain the transient temperature of a rotor of the motor in real time.

### BRIEF DESCRIPTION OF THE DRAWINGS

Fig. 1 is a schematic diagram of a power supply device according to an embodiment of the present disclosure.
Fig. 2A is a partial schematic diagram of the computing circuit according to the embodiment of Fig. 1.
Fig. 2B is a partial schematic diagram of the computing circuit according to the embodiment of Fig. 1.
Fig. 3 is a curve diagram related to the thermal model according to the embodiment of Fig. 2B.
Fig. 4 is a flow chart of a temperature measuring method according to an embodiment of the present disclosure.
Fig. 5 is a flow chart of a temperature measuring method according to another embodiment of the present disclosure.

### DETAILED DESCRIPTION

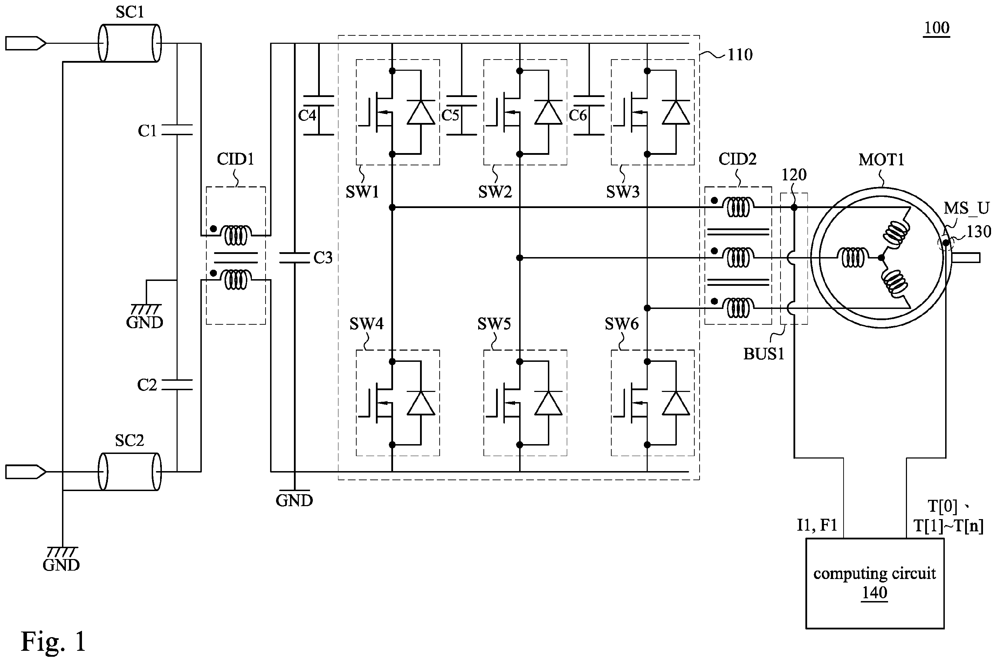

Referring to Fig.1, Fig.1 is a schematic diagram of a power supply device 100 according to an embodiment of the present disclosure. In the embodiment of Fig. 1, the power supply device 100 at least comprises cables SC1, SC2, coupled inductors CID1, CID2, capacitors C1-C6, a motor MOT1, an inverter 110, a circuit measuring device 120, a temperature sensor 130, a bus BUS1 and a computing circuit 140.

In one embodiment, the power supply device 100 can be used in a power supply system of an electric vehicle (as shown in the embodiment of Fig. 1, to power a motor MOT1). However, the present disclosure is not limited thereto. The power supply device 100 can also be used in a renewable energy system (e.g., solar energy or wind energy) or a power supply device based on direct current (e.g., a battery) feeding power to an alternating current grid. In these examples, the load may be replaced by an alternating current grid (not shown) or other similar alternating current power loads instead of the motor MOT1 shown in Fig. 1. The inverter 110 is configured to convert direct current power input (e.g., a battery, a solar panel, a wind turbine) into specific alternating current power output.

In one embodiment, the inverter 110 of the power supply device 100 comprises switches SW1-SW6. The main function of the inverter 110 is to convert the direct current input into the alternating current output of a specific specification.

In one embodiment, the switches SW1-SW6 may be switching elements such as insulated gate bipolar transistors (IGBT) or metal oxide semiconductor field effect transistors (MOSFET). The computing circuit 140 is configured to generate gate signals to drive the switches SW1-SW6, thereby controlling the operation of the switches SW1-SW6. The switches SW1-SW6 switch their switch states according to gate signals to generate three-phase AC power. The switches SW1-SW6 are controlled by precise switching operations to generate waveforms of required frequency and voltage. Three groups of the switches SW1-SW6 form a three-phase system, and each group controls the voltage of one phase, thereby forming a balanced three-phase AC power. The output frequency can be adjusted by adjusting the switching speed of switches SW1-SW6 to control an operating frequency F1 of the motor MOT1. Precise switch controlling operation can maximize the control of the motor MOT1 the circuit power consumption, reduce energy loss of the motor MOT1, and improve the system efficiency.

Furthermore, when the computing circuit 140 determines that the motor MOT1 is abnormal (e.g., the transient temperature is too high, and the service life is insufficient), the computing circuit 140 can quickly cut off power supply of the motor MOT1 by shutting down the switches SW1-SW6. Therefore, the system may be avoided from damage caused by overload or malfunction. The coordinated operation of the switches SW1-SW6 can ensure that the motor MOT1 can operate stably and efficiently.

In one embodiment, the cables SC1 and SC2 can receive input voltage and be coupled to a ground terminal GND. The cable SC1 can also be coupled to a first terminal of the capacitance C1. The first terminal of the capacitance C1 is coupled to the ground terminal GND and a first terminal of the capacitance C2. The cable SC2 can also be coupled to a second terminal of the capacitance C2. In one embodiment, the cables SC1 and SC2 can be shielded cables having surfaces coated with insulating materials.

The first input terminal of the coupled inductor CID1 is coupled to the first terminal of the capacitor C1. The first output terminal of coupled inductor CID1 is coupled to the first terminal of the capacitor C3 and the first terminal of the capacitor C4. The second input terminal of the coupled inductor CID1 is coupled to the second terminal of the capacitor C2. The second output terminal of the coupled inductor CID1 is coupled to the second terminal of the capacitor C3 and the ground terminal GND. The second terminal of the capacitor C4 is coupled to the ground terminal GND.

As shown in Fig. 1, the capacitance C5 and the capacitance C6 may also be disposed in the inverter 110. The first terminal of the switch SW1 is coupled to the capacitance C4, the capacitance C5, the first terminal of the switch SW2, the capacitance C6, and the first terminal of the switch SW3. The second terminal of the switch SW1 is coupled to the first terminal of the switch SW4. The second terminal of the switch SW2 is coupled to the first terminal of the switch SW5. The second terminal of the switch SW3 is coupled to the first terminal of the switch SW6. The second terminal of the switch SW4, the second terminal of the switch SW5, and the second terminal of the switch SW6 are all coupled to the ground terminal GND.

The inverter 110 is coupled to the input terminal of the coupled inductor CID2. The three-phase input terminal of the motor MOT1 can be connected to the output terminal of the coupled inductor CID2 through the bus BUS1.

The measuring terminal of the circuit measuring device 120 can be set between the output terminal of the coupled inductor CID2 and the three-phase input terminal of the motor MOT1, for example, set on one of the three-phase input terminals of motor MOT1 to measure the current I1 flowing into the motor MOT1. The circuit measuring device 120 can have a frequency measurement function. Since the input terminal of the motor MOT1 receives the alternating current, the circuit measuring device 120 can measure the AC frequency of the current (i.e., the operating frequency F1 of the motor MOT1) while measuring the current I1. The measuring terminal of the circuit measuring device 120 can also be set on the bus BUS1 connected to the output terminal of the coupled inductor CID2. The AC frequency mentioned above can also be obtained by other methods, such as first recording data of the current I1 and then using data analysis software to analyze the current waveform and calculate the frequency.

The measuring terminal of the temperature sensor 130 can be set on a stator MS_U of the motor MOT1 or at the winding outlet of the motor MOT1 to measure the initial temperature T[0] of the stator MS_U at the moment of starting operation (also called "initial phase") and the operating ambient temperatures T[1]-T[n] after the bus BUS1 has been operating for a period of time. Here, the "n" can be any positive integer greater than 1, representing the amount of times the temperature sensor 130 measures the stator MS_U during the operation of the motor MOT1, and it can also represent the amount of operating ambient temperatures measured by the temperature sensor 130 near the stator MS_U of the motor MOT1. In some embodiments, the measuring terminal of temperature sensor 130 can also be set outside the motor MOT1, but the present disclosure is not limited thereto.

The computing circuit 140 is coupled to the circuit measuring device 120 and the temperature sensor 130. The computing circuit 140 can receive the current I1 and the operating frequency F1 through the circuit measuring device 120, and the computing circuit 140 can receive the initial temperature T[0] and the operating ambient temperatures T[1]-T[n] through the temperature sensor 130.

In one embodiment, the computing circuit 140 of the present disclosure controls and protects the motor MOT1 from over-temperature by monitoring the temperature of the stator MS_U of the motor MOT1 and estimating the transient temperature of the rotor of the motor MOT1, and the over-temperature protecting method is to adjust the current I1 and the operating frequency F1 through the switches SW1-SW6. The following embodiments will explain in detail how the computing circuit 140 monitors and estimates the transient temperature and specific operations for the subsequent over-temperature protection.

The computing circuit 140 can estimate the motor operating temperature and the transient ideal temperature. When the difference value between the motor operating temperature and the transient ideal temperature is greater than a first threshold, it means that the motor MOT1 has deteriorated, resulting in a larger thermal resistance. In this case, the computing circuit 140 can send to a control signal to reduce the current I1 input to the motor MOT1, thereby allowing the motor MOT1 to be in a load reduction mode to extend the service life of the motor MOT1.

When the difference value between the motor operating temperature and the transient ideal temperature is greater than a second threshold, it means that the motor MOT1 has been over-deteriorated. Continued use of the motor MOT1 could cause the entire power supply device 100 to malfunction. In this embodiment, the second threshold is higher than the first threshold. In this case, the computing circuit 140 should send the control signal so that the switches SW1-SW6 in the overall inverter 110 stops transmitting current to the motor MOT1. In some embodiments, when the computing circuit 140 detects this phenomenon, it can generate and send a warning message (such as a description text, a pattern, an alarm sound) to a display, a speaker or other output interface to inform the user or maintenance personnel of the current deteriorated condition of the motor MOT1, so that the user or maintenance personnel can perform targeted repairs or maintenance.

In the embodiment mentioned above, when the difference value between the motor operating temperature and the transient ideal temperature becomes greater, it means that the motor MOT1 may be deteriorated or have insufficient service life. For example, the "rainflow counting algorithm" may be executed to estimate the service life of the motor MOT1 according to a deviation of the operating temperature of motor MOT1. When it is determined that the service life of the motor MOT1 is insufficient, the maintenance personnel may be prompted to replace it.

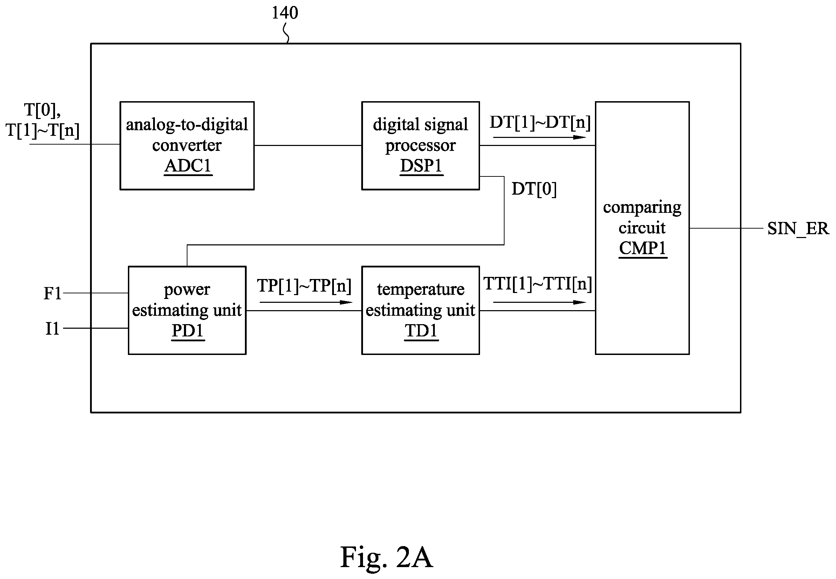

Referring to Fig. 2A, Fig. 2A is a partial schematic diagram of the computing circuit 140 according to the embodiment of Fig. 1. The embodiment of Fig. 2A illustrates an implementation and internal architecture of the computing circuit 140 according to the present disclosure. The computing circuit 140 may comprise an analog-to-digital converter ADC1, a digital signal processor DSP1, a power estimating unit PD1, a temperature estimating unit TD1, and a comparing circuit CMP1.

In the embodiment of Fig. 2A, the input terminal of the analog-to-digital converter ADC1 can sequentially receive the initial temperature T[0] and the operating ambient temperature T[1]-T[n] through the temperature sensor 130, and the output terminal of the analog-to-digital converter ADC1 can be coupled to the digital signal processor DSP1. The initial temperature T[0] and the operating ambient temperature T[1]-T[n] are both analog signals. Through the analog-to-digital converter ADC1 and the digital signal processor DSP1, the initial temperature T[0] and the operating ambient temperature T[1]-T[n] can be converted into the digital initial temperature T[0] and the digital ambient temperature T[1]-T[n], and the digital initial temperature DT[0] and the digital ambient temperature DT[1]-DT[n] are both digital signals.

The input terminal of the power estimating unit PD1 receives the current I1 and the operating frequency F1, and calculates to obtain a copper loss and iron loss of the motor MOT1 based on the current I1 and the operating frequency F1, thereby calculating to obtain the internal resistance of the motor MOT1. The current I1 is, for example, the current flowing into the motor MOT1; and the operating frequency F1 is, for example, the operating frequency of the motor MOT1.

Furthermore, the power estimating unit PD1 can be coupled to the digital signal processor DSP1 and receive the digital initial temperature DT[0]. The power estimating unit PD1 calculates to obtain the transient power TP[1] based on the digital initial temperature DT[0] and the internal resistance of the motor MOT1. After obtaining the transient power TP[1], the power estimating unit PD1 can continue to calculate to obtain transient power TP[2] based on the transient power TP[1], the current I1, and the operating frequency F1. Similarly, the power estimating unit PD1 can sequentially calculate to obtain the transient power TP[3]-TP[n].

The temperature estimating unit TD1 is coupled to the power estimating unit PD1 and receives the transient power TP[1]-TP[n] from the power estimating unit PD1. The temperature estimating unit TD1 can calculate to obtain the transient ideal temperature TTI[1]-TTI[n] based on the transient power TP[1]-TP[n].

The comparing circuit CMP1 can sequentially receive the digital ambient temperatures DT[1]-DT[n] from the digital signal processor DSP1 and the transient ideal temperatures TTI[1]-TTI[n] from the temperature estimating unit TD1. The comparing circuit CMP1 may be provided a transfer function. The transfer function is set according to location of the measuring terminal of the temperature sensor 130 in the motor MOT1 and the thermal conductivity of the conductive medium (e.g., copper wire, heat pipe or heat conductive metal sheet, etc.) at the measuring terminal of the temperature sensor 130. The comparing circuit CMP1 can estimate the motor operating temperature of the motor MOT1 according to the digital ambient temperatures DT[1]-DT[n] through the transfer function. The comparing circuit CMP1 can sequentially compare the motor operating temperature corresponding to the digital ambient temperatures DT[1]-DT[n] with the transient ideal temperatures TTI[1]-TTI[n] and output a control signal SIN_ER based on the comparison result.

For example, when the comparing circuit CMP1 receives the digital ambient temperature DT[1] and the transient ideal temperature TTI[1], the digital ambient temperature DT[1] can be converted into the corresponding motor operating temperature. When the difference value between the motor operating temperature and transient ideal temperature TTI[1] is greater than the first threshold, the comparing circuit CMP1 can send the control signal SIN_ER to reduce the current I1 input to the motor MOT1. When the difference value between the motor operating temperature and the transient ideal temperature TTI[1] is greater than the second threshold, the comparing circuit CMP1 can send the control signal SIN_ER so that the switches SW1-SW6 in the inverter 110 stops transmitting current to the motor MOT1.

As shown in Figs. 1 and 2A, the computing circuit 140 can send the control signal to cause switches SW1-SW6 in inverter 110 to stop transmitting current to the motor MOT1. In some embodiments, when the computing circuit 140 detects this phenomenon, it can generate and send the warning message (such as description text, pattern, alarm sound) to a display, a speaker or other output interface to inform the user or maintenance personnel of the current deteriorated condition of the motor MOT1, so that the user or maintenance personnel can perform targeted repairs or maintenance.

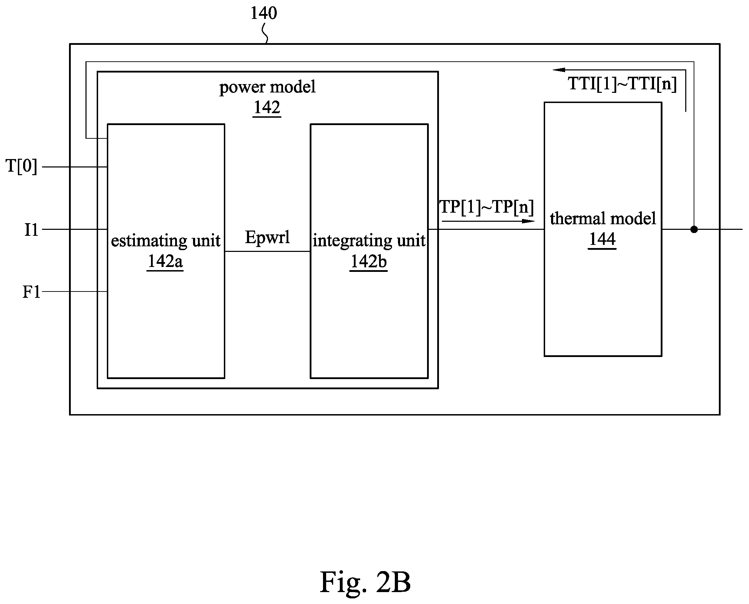

The embodiment of the computing circuit 140 in the present disclosure is not limited to the architecture shown in Fig. 2A. Referring to Fig. 2B, Fig. 2B is a partial schematic diagram of the computing circuit 140 according to another embodiment. Specifically, unlike the computing circuit 140 in Fig. 2A, the computing circuit 140 in Fig. 2B includes a power model 142 and a thermal model 144.

In the embodiment of Fig. 2B, the power model 142 includes an estimating unit 142a and an integrating unit 142b.

Specifically, the computing circuit 140 may execute the power model 142 and the thermal model 144 to calculate to obtain the transient ideal temperatures TTI[1]-TTI[n].

In the initial phase, the computing circuit 140 may receive the initial temperature T[0] through the temperature sensor 130, the computing circuit 140 may execute the power model and calculate to obtain the transient power TP[1] based on the initial temperature T[0], the current I1 and the operating frequency F1 measured by the circuit measuring device 120 in the initial phase. After obtaining the transient power TP[1], the computing circuit 140 may further execute the thermal model and calculate to obtain the transient ideal temperature TTI[1] of the motor MOT1 based on the transient power TP[1].

After the initial phase, the power supply device 100 may continue to operate, and the temperature in the motor MOT1 may increase over time, thereby causing the thermal resistance of the motor MOT1 to change as the temperature increases. When the power supply device 100 is operating, the computing circuit 140 can first receive the initial temperature T[0] through the temperature sensor 130, and then execute the power model, calculate to obtain the transient power TP[2] of the motor MOT1 based on the transient ideal temperature TTI[1], the current I1 and the operating frequency F1 measured in real time by the circuit measuring device 120. After obtaining the transient power TP[2], the computing circuit 140 can execute the thermal model, calculate to obtain the transient ideal temperature TTI[2] of the motor MOT1 based on the transient power TP[2].

The computing circuit 140 can continuously execute the power model and the thermal model, and calculate to obtain a transient ideal temperature TTI[3] according to the current I1, the operating frequency F1 and the transient ideal temperature TTI[2]. The computing circuit 140 can continuously iterate according to the operation mentioned above, and calculate to obtain the temperature value of the motor MOT1 at a certain time point based on the current I1 and the operating frequency F1 of the motor MOT1 at that time point.

In summary, according to the power model and the thermal model, the power supply device 100 can instantly calculate to obtain the transient temperature of the motor MOT1 by measuring the operating frequency F1 and the current I1 of the motor MOT1.

In addition to the above functions, in the embodiment of Fig. 1, the computing circuit 140 of the power supply device 100 can further compare the transient ideal temperature of the rotor of the motor MOT1 with the operating ambient temperature measured by the temperature sensor at a certain time point after the power supply device 100 operates from the initial phase to the time point, and then determine whether the motor MOT1 is abnormal.

The computing circuit 140 can estimate the transient ideal temperature of the rotor of motor MOT1 through the power model and thermal model at the time point mentioned above. The computing circuit 140 can receive the operating ambient temperature measured by temperature sensor 130 at that time point. Furthermore, the computing circuit 140 can set the transfer function mentioned above. Based on the transfer function, the computing circuit 140 can convert the operating ambient temperature into the motor operating temperature of motor MOT1. In other words, the computing circuit 140 can estimate the motor operating temperature of the motor MOT1 based on the transfer function and the operating ambient temperature. The computing circuit 140 can compare the motor operating temperature of the motor MOT1 with the transient ideal temperature to determine whether an abnormality occurred in motor MOT1 at that time point.

In the initial phase, the estimating unit 142a can estimate a motor power loss Epwrl of the motor MOT1 according to the initial temperature T[0], the operating frequency F1 and the current I1 of the motor MOT1.

The motor power loss Epwrl refers to the power loss of the motor MOT1 under an ideal condition. The motor power loss Epwrl can be calculated by monitoring changes in the operating frequency F1 and the current I1 of the motor MOT1.

In this embodiment, the integrating unit 142b may receive the motor power loss Epwrl from the estimating unit 142a, and transmit the motor power loss Epwrl received in the initial phase as the transient power TP[1] to the thermal model.

After receiving the transient power TP[1] from the integrating unit 142b, the thermal model 144 may calculate to obtain the transient ideal temperature TTI[1] based on the transient power TP[1].

After the initial phase, the thermal model 144 can transmit the transient ideal temperature TTI[1] to the power model 142. The power model 142 can correspondingly output the transient power TP[2] to the thermal model 144, enabling the thermal model 144 to calculate to obtain the transient ideal temperature TTI[2]. Similarly, the computing circuit 140 can continue to calculate to obtain the transient ideal temperatures TTI[3]-TTI[n].

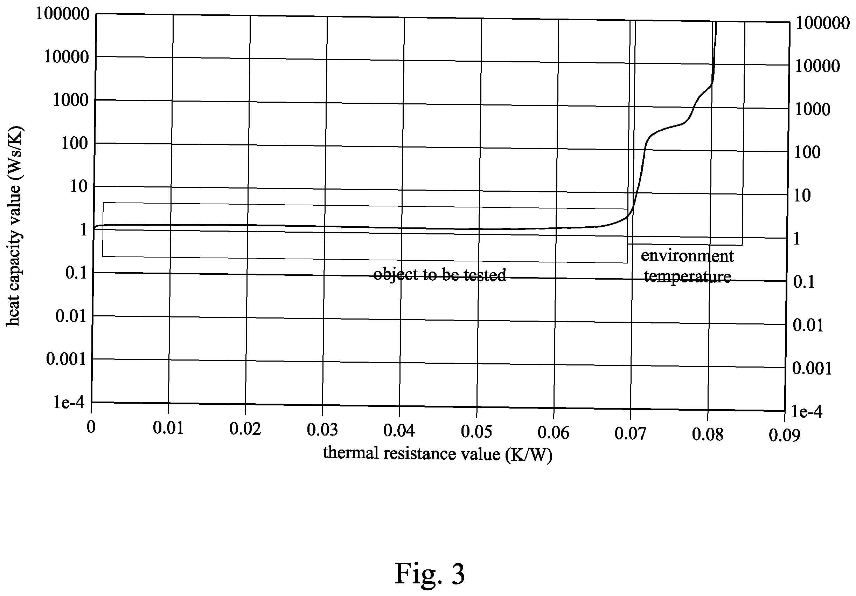

Referring to Fig. 3, Fig. 3 is a curve diagram related to the thermal model 144 according to the embodiment of Fig. 2B. The graph in Fig. 3 includes a measurement curve, the measurement curve represents the relationship between the thermal resistance and thermal capacitance of stator of the motor MOT1. This measurement curve is obtained by integrating the measured values of thermal resistance of stator of the motor MOT1 over time with the measured values of thermal capacitance of stator of the motor MOT1 over time to create a graph related to the thermal model.

In Fig. 3, the measurement curve is measurement data pre-stored in a memory device built in the computing circuit 140. The measurement curve is obtained by measuring the thermal resistance and thermal capacitance of the stator (object to be tested) used by the power supply device 100 and the circuit operating environment.

In one embodiment, thermal model 144 is established based on laboratory measurement results. That is, an environment equivalent to a using environment equivalent of the power supply device 100 is constructed in a laboratory. Under controlled an environment temperature and a constant on-current, the input current and AC frequency of the motor MOT1 are measured, and the motor power loss of motor MOT1 is calculated based on the current and frequency. In some embodiments, the relationship between the motor power loss and the environment temperature can be recorded as a comparison table or a database model to obtain thermal model 144.

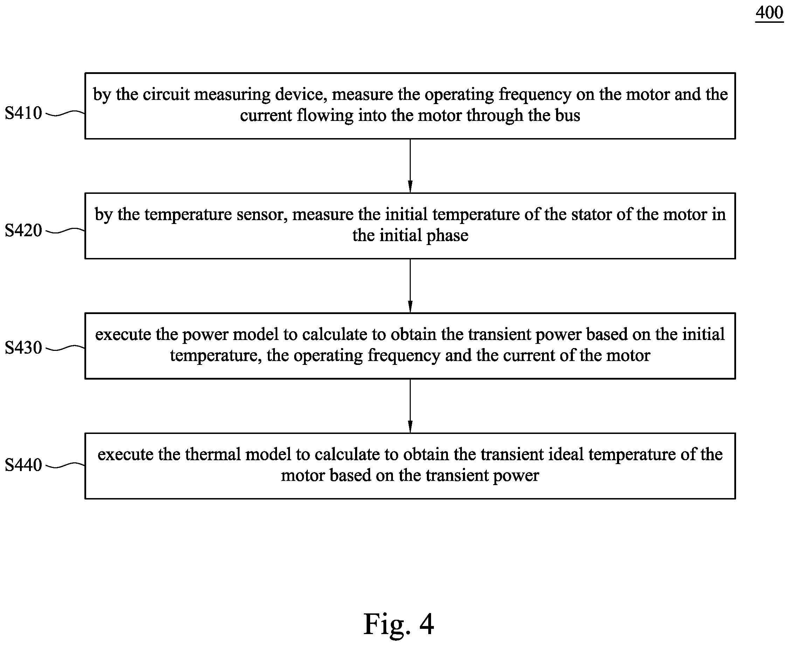

Referring to Fig. 4, Fig. 4 is a flow chart of a temperature measuring method 400 according to an embodiment of the present disclosure. The temperature measuring method 400 is configured to illustrate the operation of the power supply device 100 of the embodiment in Fig. 2B.

In step S410, the power supply device 100 may measure the operating frequency F1 on the motor MOT1 and the current I1 flowing into the motor MOT1 through the bus by the circuit measuring device 120.

In step S420, the power supply device 100 may measure the initial temperature T[0] of the stator MS_U of the motor MOT1 in the initial phase by the temperature sensor 130.

In step S430, the power supply device 100 may execute the power model 142 to calculate to obtain the transient power TP[1] based on the initial temperature T[0], the operating frequency F1 and the current I1 of the motor MOT1.

In step S440, the power supply device 100 may execute the thermal model 144 to calculate to obtain the transient ideal temperature TTI[1] of the motor MOT1 based on the transient power TP[1].

After the step S440, the power supply device 100 may receive the transient ideal temperature TTI[1] and continuously calculate to obtain the transient ideal temperatures TTI[2]~TTI[n] according to the temperature measuring method 400.

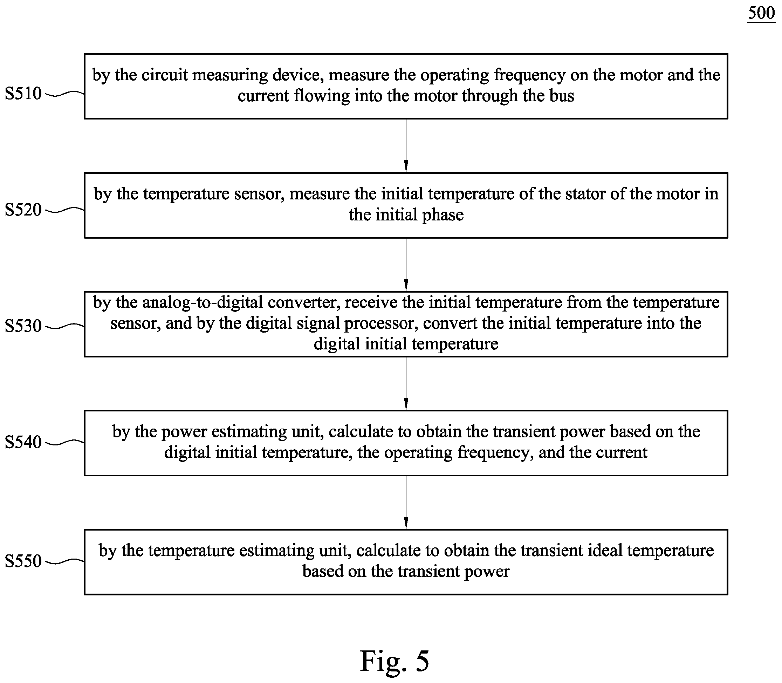

Referring to Fig. 5, Fig. 5 is a flow chart of a temperature measuring method 500 according to another embodiment of the present disclosure. The temperature measuring method 500 is configured to illustrate the operation of the power supply device 100 of the embodiment in Fig. 2A.

In step S510, the power supply device 100 may measure the operating frequency F1 on the motor MOT1 and the current I1 flowing into the motor MOT1 through the bus by the circuit measuring device 120.

In step S520, the power supply device 100 may measure the initial temperature T[0] of the stator MS_U of the motor MOT1 in the initial phase by the temperature sensor 130.

In step S530, the power supply device 100 may receive the initial temperature T[0] from the temperature sensor 130 by the analog-to-digital converter ADC1 and convert the initial temperature T[0] into the digital initial temperature DT[0] by the digital signal processor DSP1.

In step S540, the power supply device 100 may calculate to obtain the transient power TP[1] based on the digital initial temperature DT[0], the operating frequency F1, and the current I1 by the power estimating unit PD1.

In step S550, the power supply device 100 can calculate to obtain the transient ideal temperature TTI[1] based on the transient power TP[1] by the temperature estimating unit TD1.

After step S550 , the power supply device 100 may receive the transient ideal temperature TTI[1] and continuously calculate to obtain the transient ideal temperatures TTI[2]-TTI[n] based on the temperature measuring method 500.

In summary, based on the power model and thermal model, the power supply device 100 of the present disclosure can instantly calculate to obtain the transient temperature of the motor by measuring the current and the operating frequency of the motor. In addition, in some circumstances, the power supply device 100 of the present disclosure can also determine whether the motor have deteriorated by comparing the transient ideal temperature with the ambient temperature when the system is operating.

## Claims

1. A power supply device (100), **characterized by** comprising:
a motor (MOT1);
a circuit measuring device (120), configured to measure an operating frequency (F1) of the motor and a current (I1) flowing into the motor through a bus (BUS1);
a temperature sensor (130), configured to measure an initial temperature (T[0]) of a stator (MS_U) of the motor in an initial phase; and
a computing circuit (140), coupled to the circuit measuring device and the temperature sensor, and the computing circuit being configured to:
execute a power model (142), based on the initial temperature, the operating frequency and the current, calculate to obtain a first transient power (TP[1]) of the motor; and
execute a thermal model (144), based on the first transient power to calculate to obtain a first transient ideal temperature (TTI[1]) of the motor.

2. The power supply device of claim 1, wherein the computing circuit is further configured to:
execute the power model to obtain a second transient power (TP[2]) of the motor based on the first transient ideal temperature, the operating frequency and the current when the power supply device is operating; and
execute the thermal model to obtain a second transient ideal temperature (TTI[2]) of the motor based on the second transient power.

3. The power supply device of claim 1, wherein the computing circuit is further configured to:
measure an operating ambient temperature (T[1]) by the temperature sensor when the power supply device is operating;
estimate a motor operating temperature of the motor based on the operating ambient temperature and a transfer function between the motor and the temperature sensor; and
compare the motor operating temperature with the first transient ideal temperature to determine whether the motor is abnormal.

4. The power supply device of claim 3, wherein,
in response to a difference value between the motor operating temperature and the first transient ideal temperature being higher than a first threshold, the computing circuit sends a control signal (SIN_ER) to reduce the current flowing through the motor; and
in response to the difference value between the motor operating temperature and the first transient ideal temperature being higher than a second threshold, the computing circuit sends the control signal (SIN_ER) to stop the motor from operating, and the second threshold is higher than the first threshold.

5. The power supply device of claim 1, wherein
the power model estimates a motor power loss of the motor based on the initial temperature, the operating frequency and the current of the motor, and calculates to obtain the first transient power based on the motor power loss.

6. A power supply device (100), **characterized by** comprising:
a motor (MOT1);
a circuit measuring device (120),, configured to measure an operating frequency (F1) of the motor and a current (I1) flowing into the motor through a bus (BUS1);
a temperature sensor (130), configured to measure an initial temperature (T[0]) of a stator (MS_U) of the motor in an initial phase; and
a computing circuit (140), coupled to the circuit measuring device and the temperature sensor, and the computing circuit comprises:
an analog-to-digital converter (ADC1), configured to receive the initial temperature from the temperature sensor, wherein the initial temperature is an analog signal;
a digital signal processor (DSP1), configured to convert the initial temperature (T[0]) into a digital initial temperature (DT[0]), wherein the digital initial temperature is a digital signal;
a power estimating unit (PD1), configured to calculate to obtain a first transient power (TP[1]) of the motor based on the digital initial temperature, the operating frequency, and the current; and
a temperature estimating unit (TD1), configured to calculate to obtain a first transient ideal temperature (TTI[1]) based on the first transient power.

7. The power supply device of claim 6, wherein,
the power estimating unit calculates to obtain a second transient power (TP[2]) of the motor based on the first transient ideal temperature, the operating frequency and the current when the power supply device is operating; and
the temperature estimating unit calculates to obtain a second transient ideal temperature (TTI[2]) of the motor based on the second transient power.

8. The power supply device of claim 6, wherein the computing circuit further comprises:
a comparing circuit (CMP1), coupled to the digital signal processor and the temperature estimating unit,
wherein:
the temperature sensor measure an operating ambient temperature (T[1]) of the stator when the power supply device is operating;
the analog-to-digital converter and the digital signal processor convert the operating ambient temperature into a digital ambient temperature (DT[1]), the digital ambient temperature is a digital signal;
the comparing circuit estimates a motor operating temperature of the motor based on the digital ambient temperature and a transfer function between the motor and the temperature sensor; and
the comparing circuit compares the motor operating temperature with the first transient ideal temperature to determine whether the motor is abnormal.

9. The power supply device of claim 8, wherein,
in response to a difference value between the motor operating temperature and the first transient ideal temperature being higher than a first threshold, the comparing circuit sends a control signal (SIN_ER) to reduce the current flowing through the motor; and
in response to the difference value between the motor operating temperature and the first transient ideal temperature being higher than a second threshold, the comparing circuit sends the control signal (SIN_ER) to stop the motor from operating, and the second threshold is higher than the first threshold.

10. The power supply device of claim 6, wherein the power estimating unit estimates a motor power loss of the motor based on the initial temperature, the operating frequency and the current of the motor, and calculates to obtain the first transient power based on the motor power loss.
